Europäisches Patentamt

**European Patent Office**

**Office européen des brevets**

(11) Publication number : **0 508 748 A2**

# (12) EUROPEAN PATENT APPLICATION

(21) Application number : **92303111.6**

(22) Date of filing : **08.04.92**

(51) Int. Cl.⁵ : **H01L 21/00**

(30) Priority : **09.04.91 US 682285**

(43) Date of publication of application :
**14.10.92 Bulletin 92/42**

(84) Designated Contracting States :
**DE FR GB**

(71) Applicant : **EATON CORPORATION**
**Eaton Center, 1111 Superior Avenue**
**Cleveland, Ohio 44114-2584 (US)**

(72) Inventor : **Bellamy, Brad Lee**
**2112 Rick Whinery**
**Austin, Texas 78728 (US)**

(74) Representative : **Wright, Peter David John et al**
**R.G.C. Jenkins & Co. 26 Caxton Street**
**London SW1H 0RJ (GB)**

(54) **Wafer centering system.**

(57)    A system for positioning a wafer (12) at a station within a wafer processing system such that the center of mass of the wafer coincides with the center of the rotatable chuck (22) at the station. A signal representative of the position of the wafer with respect to the rotatable chuck is produced by a sensor (54) and is utilized to determine a vector which defines distance and direction of the centering error between the center of rotation of the chuck and the center of mass of the wafer. The chuck and wafer are rotationally indexed through an angle to align the foregoing vector with a line which approximates the arcuate path traversed by the center of mass of the wafer when it is subsequently conveyed within the system. A transfer arm (44) is utilized to convey the wafer through the foregoing arcuate path with respect to the chuck so that the center of mass of the wafer coincides with the center of rotation of the chuck when the wafer is subsequently placed on same.

FIG 1

This invention relates, in general, to apparatus for transferring a semi-conductor wafer between processing stations within a wafer processing system and, more particularly, to wafer transfer apparatus that has the capability of determining and correcting wafer positioning errors at the various processing stations within the wafer processing system.

Typically, in the production of integrated circuits on semi-conductor wafers, such wafers are stored and transported in a cassette wafer holder in which the wafers are placed in closely spaced, parallel horizontal slots. Processing of the wafers requires that the wafers be withdrawn from the cassette holder, usually one at a time, and transferred to the wafer processing machine. Such a machine can include a number of processing modules such as a photoresist coater, developer, wafer scrubber or bake module, etc. After wafer processing has been completed, the wafer is returned to another cassette holder for removal from the processing device.

Centering of the wafer at the individual processing stations can be accomplished by the use of centering cones which contact the edge of the wafer and cause the wafer to slide along the surface of the cones and the surface of a chuck located at the processing station in order to position the wafer on the chuck. Alternatively, spring-type fingers can be used to engage the edge of the wafer causing the wafer to be positioned on the chuck by sliding action. With either of the foregoing approaches, if the wafer has flats or notches on the periphery thereof for positioning purposes at the various processing stations, true mass centering of the wafer on the chuck is difficult, if not impossible, to achieve.

In any wafer handling system, the minimization of particulate contamination is of primary importance since such particulates can degrade or destroy the circuits subsequently etched on the wafer. To prevent particulate contamination, it is necessary to minimize abrasion and/or chipping of the surfaces and the edge of the wafer. Thus, any sliding motion of the wafer against centering cones or on a supporting surface must be minimized or eliminated, and contact with the edge of the wafer must be minimal and extremely gentle. Furthermore, any handling or transfer device should require a minimum of moving components to decrease the number of particles generated which could contaminate the processing area.

It is desirable in a wafer processing system to center the wafer on the vacuum chucks within the processing modules such that the center of mass of the wafer coincides with the geometric center of the vacuum chuck. Irregularities such as the inclusion of flats or notches on the edge of the wafer for positioning purposes can cause the center of mass of the wafer to differ from its geometric center. Because the vacuum chucks within the processing modules can rotate at high speeds, approximately 10,000 rpm, the center of mass of the wafer should coincide with the geometric center of the chuck to minimize vibration of the wafer during the processing operation. The wafer processing systems presently available do not adequately provide for accurately positioning the wafer on the rotatable vacuum chucks within the processing modules such that the center of mass of the wafer coincides with the geometric center of the chuck. In other situations where the wafer is not rotated at high speeds, it is often desirable to ignore the flats or notches on the periphery of the wafer and geometrically center the wafer on the chuck.

The present invention provides a solution to the problem of positioning the wafer on the vacuum chucks which rotate at high speeds within the wafer processing system such that the center of mass of the wafer coincides with the geometric center of the chuck without any sliding motion between the wafer and the chuck. In those cases where high speed rotation is not utilized at a processing module, the present invention provides for geometric centering of the wafer within the module. The foregoing mass centering and geometric centering is accomplished through the use of a sensor located in the end of a transfer arm which is oriented adjacent the edge of the wafer to produce an output signal as the chuck, with the wafer thereon, rotates. The foregoing output signal, in conjunction with associated software, determines a vector which defines the distance and direction of the centering error between the center of rotation of the chuck and the center of mass of the wafer. The chuck with wafer thereon is then rotationally indexed through an angle to align the foregoing centering error vector with a line which approximates the arcuate path traversed by the center of mass of the wafer when it is subsequently conveyed by the transfer arm. The wafer is then transferred from the vacuum chuck to the transfer arm and moved through the foregoing arcuate path so that the center of mass of the wafer coincides with the center of rotation of the chuck when the wafer is subsequently placed on same. In this manner, the center of mass of the wafer will coincide with the center of rotation of the chuck thus minimizing vibration of the wafer when the chuck with the wafer thereon is rotated. Geometric centering of the wafer is achieved in the same manner except that the associated software calculates the geometric center of the wafer as if the flats or notches were not present.

In accordance with the above, the primary object of the present invention is to provide apparatus for centering wafers at the processing stations within a wafer processing system.

Another object of the present invention is to provide apparatus for centering wafers at a processing station within a wafer processing system without any sliding motion between the wafer and the chuck which supports same at the processing station.

Another object of the present invention is to provide apparatus which determines the relative location of the center of mass of a wafer with respect to the center of rotation of a vacuum chuck at a processing station.

Another object of the present invention is to provide apparatus which determines a vector which defines the distance and direction of the centering error between the center of rotation of the vacuum chuck and the center of mass of the wafer which has been placed thereon.

Another object of the present invention is to provide apparatus which permits the chuck with the wafer thereon to be rotationally indexed through an angle to align the centering error vector with a line which approximates the arcuate path traversed by the center of mass of the wafer when it is subsequently conveyed by a transfer arm and replaced on the chuck.

Other objects and advantages of the present invention will become more apparent during the course of the following description when taken in connection with the accompanying drawings.

In the drawings, wherein like numerals are employed to designate like parts throughout the same:

Figure 1 is a partial cross-sectional elevational view of a wafer processing system illustrating the vacuum chucks within various processing modules and the transfer arms to transfer the wafers between adjacent modules.

Figure 2 is a top plan view of the apparatus illustrated in Figure 1.

Figures 3 through 5 illustrate various angular rotations required to the align the vector which connects the center of rotation of the chuck and the center of mass of the wafer with a line which approximates the arcuate path traversed by the center of mass of the wafer when it is subsequently conveyed by the transfer arm and replaced on the chuck.

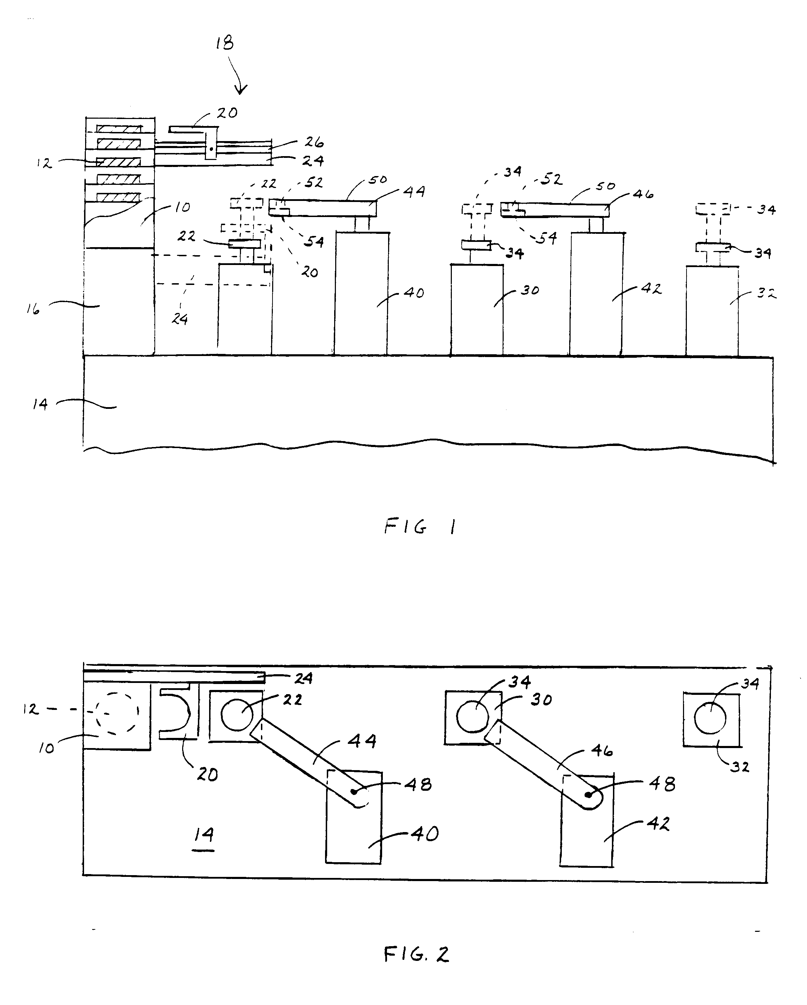

Referring now to the drawings where the illustrations are for the purpose of describing the preferred embodiment of the present invention and are not intended to limit the invention described herein, Figure 1 is a partial cross-sectional elevational view and Figure 2 is a top plan view of the wafer handling apparatus of the present invention. As such, the wafer handling apparatus includes a cassette holder 10 which holds a plurality of wafers 12 that are oriented in a stacked relationship. The cassette holder 10 is mounted to the frame 14 of the machine by a bracket 16 or alternatively can be received within an elevator chamber (not shown) provided within the frame so as to permit the cassette holder to be indexable in the vertical direction. An indexer module, shown generally by the numeral 18, is provided adjacent the cassette holder 10 and includes a wafer pick arm 20 and an alignment chuck 22. The wafer pick arm 20 is supported by a bracket 24 and is slidingly movable in the horizontal direction in a slot 26 provided therein. Bracket 24 and wafer pick arm 20 are movable in the vertical direction allowing the wafer pick arm 20 to be alignable with each wafer in the cassette holder 10. Alternatively, if the cassette holder 10 is received within an elevator chamber, movement of the wafer pick arm 20 will be limited to the horizontal direction inasmuch as the elevator chamber provides the vertical movement required to align the wafer 12 with the wafer pick arm 20. In either case, when the bracket 24 and wafer pick arm 20 are in their stored or neutral position, (shown dotted in Figure 1), both are located below the alignment chuck 22 when the chuck 22 is in its raised position. When the wafer pick arm 20 is retrieving a wafer 12 from the cassette holder 10, movement of the wafer pick arm 20 in the horizontal direction is in a plane located above the top surface of the alignment chuck 22. Alignment chuck 22 is rotatable and can move vertically. Ports (not shown) are provided within the alignment chuck 22 permitting the passage of vacuum to the top surface thereof in order to secure the wafer 12 to the chuck 22.

Wafer processing modules 30 and 32 are positioned adjacent to indexer module 18. Processing modules 30 and 32 can be any one of a number of processing modules such as a coater, developer, or scrubber module. Wafer processing modules 30 and 32 are provided with a rotatable vacuum chuck 34 on which the wafer being processed is positioned. Ports (not shown) are provided within the vacuum chuck 34 permitting the passage of vacuum to the top surface thereof in order to secure the wafer 12 to the chuck 34 during processing. The alignment chuck 22, vacuum chuck 34 and wafer 12 are generally circular in configuration and the diameter of the wafer 12 is greater than the diameter of each of the foregoing chucks.

Handler modules 40 and 42 are located between indexer module 18 and wafer processing module 30 and between processing modules 30 and 32, respectively, and control the respective rotation of the transfer arms 44 and 46 about a pivot point 48 located at one end thereof. Rotation of the transfer arms 44 and 46 is in a horizontal plane. The top surface 50 of the opposite end of the transfer arms 44 and 46 is provided with a port 52 through which vacuum is supplied in order to secure the wafer 12 to the transfer arms 44 and 46 to effect transfer of the wafer 12 between indexer module 18 and processing module 30 and between processing module 30 and processing module 32, respectively. The underside of the transfer arms 44 and 46 adjacent the end which contacts the wafer 12 is provided with a recess in which a sensor 54 is located. As the wafer 12 is rotated by the alignment chuck 22 or the vacuum chuck 34, the sensor 54 provides an output signal representative of the position of the edge of the wafer 12 with respect to the sensor 54. The foregoing output signal is used in conjunction with software to determine the position of the wafer 12 on the alignment chuck 22 and on the vacuum chucks 34, as hereinafter described.

The sensor 54 can be a capacitive sensor of the non-contact, position measuring type such as Capacitec Model HPL-7074-0020-X, or the like. It should be noted that other non-contact sensors can be utilized, such as optical beam break or optical reflective sensors, to determine the position of the geometric center of the wafer or the center of the mass of the wafer relative to the geometric center of the alignment chuck 22 or the vacuum chucks 34.

Operationally, the bracket 24 and the wafer pick arm 20 are caused to move vertically upwardly from their stored or neutral position (shown dotted in Figure 1) to a level such that the wafer pick arm 20 is adjacent the wafer 12, located in cassette holder 10, to be processed. The wafer pick arm 20 is caused to move horizontally to retrieve the wafer 12 from the cassette holder 10 and transports same so as to be positioned above the alignment chuck 22. The alignment chuck 22 is raised (dotted position in Figure 1) and the bracket 24 and the wafer pick arm 20 are lowered to be adjacent the alignment chuck 22 permitting the transfer of the wafer 12 onto the chuck 22. Vacuum is applied through the ports in the alignment chuck 22 in order to secure the wafer 12 to the top surface thereof. The bracket 24 and the wafer pick arm 20 move vertically downwardly to their stored or neutral position below the alignment chuck 22. The transfer arm 44 is then rotated about its pivot point 48 so as to be adjacent to wafer 12 on alignment chuck 22. The top surface 50 of the transfer arm 44 is approximately 1/16 inch below the top surface of the alignment chuck 22. The alignment chuck 22 is rotated while sensor 54 located within transfer arm 44 and adjacent the outer end thereof detects the position of the edge of the wafer 12 relative to the transfer arm 44 and produces a voltage representative of the foregoing position. Through various software techniques, a vector defining the distance and direction of the centering error between the center of the alignment chuck 22 and the geometric center of the wafer 12 is calculated. The alignment chuck 22 with the wafer 12 thereon is then rotationally indexed through an angle to align the foregoing centering error vector with a line which approximates the arcuate path traversed by the center of the wafer 12 when it is subsequently conveyed by the transfer arm 44. The alignment chuck 22 is then lowered to transfer the wafer 12 onto the outer end of the transfer arm 44. The wafer 12 is secured to the outer end of the transfer arm 44 for conveyance purposes by vacuum which is applied through port 52 to the underside of the wafer 12 adjacent an edge thereof. The transfer arm 44 with the wafer 12 thereon is rotated through the foregoing arcuate path aligning the geometric center of the wafer 12 with the center of rotation of the alignment chuck 22 associated with the indexer module 18. The alignment chuck 22 associated with the indexer module 18 is then raised to transfer the wafer 12 from the transfer arm 44 to the alignment chuck 22. If desired, additional processing can be performed, such as rotating the wafer to orient the flats or notches on the periphery thereof. Also if desired, the transfer arm 44 can be rotated to a neutral position between the indexer module 18 and the wafer processing module 30, and the alignment chuck 22 is lowered into the indexer module 18.

In order to transfer the wafer 12 from the indexer module 18 to the wafer processing module 30, the alignment chuck 22 is raised (dotted position in Figure 1) so that the top surface thereof is slightly above the top surface of the transfer arm 44. The transfer arm 44 is then rotated about pivot point 48 from its neutral position between the indexer module 18 and the wafer processing module 30 to a position adjacent the alignment chuck 22 in the indexer module 18. The transfer arm 44 is positioned under the wafer 12, and the alignment chuck 22 is lowered to transfer the wafer 12 onto the outer end of transfer arm 44. The wafer 12 is secured to the outer end of the transfer arm 44 for conveyance purposes by vacuum which is applied through port 52 to the underside of the wafer 12 adjacent the edge thereof. The transfer arm 44 is then rotated about pivot point 48 so as to be adjacent to and above the vacuum chuck 34 associated with the wafer processing module 30. The vacuum chuck 34 associated with the processing module 30 is raised (dotted position in Figure 1) causing the wafer 12 to be transferred from the transfer arm 44 onto the vacuum chuck 34. Vacuum is supplied through the ports provided in the vacuum chuck 34 in order to secure the wafer 12 to the top surface of the chuck 34. The vacuum chuck 34 is rotated while sensor 54 located within transfer arm 44 is used to detect the position of the edge of the wafer 12 relative to the transfer arm 44. The sensor 52 produces a voltage representative of the location of the edge of the wafer 12, or the alignment flats or notches on the wafer, with respect to the sensor 52. Through various software techniques, a vector defining the distance and direction of the centering error between the center of rotation of the vacuum chuck 34 and the center of mass of the wafer 12 is calculated. The vacuum chuck 34 with the wafer 12 thereon is then rotationally indexed through an angle to align the foregoing centering error vector with a line which 0approximates the arcuate path that is traversed by the center of mass of the wafer 12 when it is subsequently conveyed by the transfer arm 44. The vacuum chuck 34 associated with the processing module 30 is then lowered to transfer the wafer 12 onto the outer end of the transfer arm 44. The wafer 12 is secured to the outer end of the transfer arm 44 for conveyance purposes by vacuum which is applied through port 52 to the underside of the wafer 12 adjacent an edge thereof. The transfer arm 44 with the wafer 12 thereon is then rotated through the foregoing arcuate path so as to align the center of mass of the wafer 12 with the center of rotation of the vacuum chuck 34 of the processing module 30. The vacuum chuck 34 associated with the processing module 30 is then raised (dotted position in Figure 1) to transfer the wafer 12 from the transfer arm 44 onto the chuck 34. If desired, the transfer arm 44 can be rotated to its neutral position between the indexer module 18 and the processing module 30, and the vacuum chuck 34 associated with the processing module 30 is lowered into module 30 to commence processing of the wafer 12.

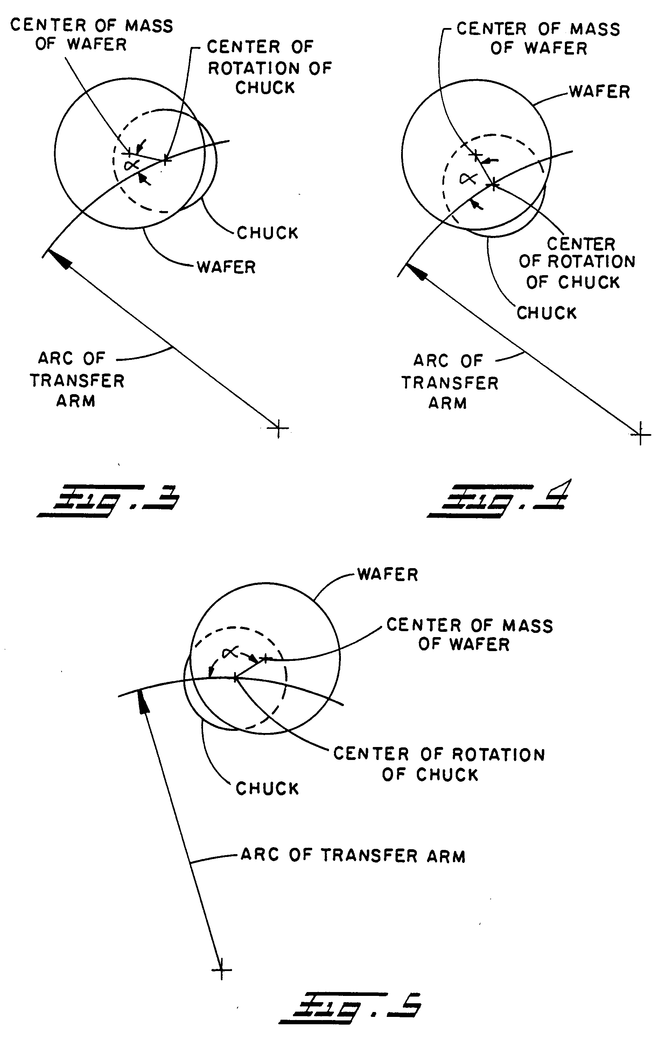

Referring now to Figures 3 through 5, four conditions are illustrated with respect to the rotational indexing that is required in each case so as to align the centering error vector with a line that approximates the arcuate path that is traversed by the wafer 12 when it is subsequently conveyed by the transfer arm 44. In Figure 3, the orientation of the foregoing vector differs from orientation of the line that approximates the arcuate path by an arbitrary angle less than 90°. In Figure 4, the foregoing orientation differs by 90°, whereas in Figure 5, the orientation differs by more than 90°. Similar figures could be developed for orientation differences between 180° and 360°. As can be seen from these Figures, if both the vacuum chuck 34 and the transfer arm 44 are constrained to rotate only in one direction (clockwise or counterclockwise), the angle through which the vacuum chuck 34, with the wafer 12 thereon, must be rotationally indexed can be up to 360°. If either the vacuum chuck 34 or the transfer arm 44 can move in both directions (clockwise and counterclockwise), then the angle through which the vacuum chuck 34, with the wafer 12 thereon, must be rotationally indexed can be up to 180°. If both the vacuum chuck 34 and the transfer arm 44 can move in both directions (clockwise and counterclockwise), then the angle through which the vacuum chuck 34, with the wafer 12 thereon, must be rotationally indexed can be up to 90°.

In order to transfer the wafer 12 from wafer processing module 30 to wafer processing module 32, the same procedure is utilized as just described for the transfer of the wafer 12 from the indexer module 18 to the wafer processing module 30, however, transfer arm 46 is utilized. In this case, mass centering of the wafer 12 on the vacuum chuck 34 associated with wafer processing module 32 is achieved by means of sensor 54 located within the outer end of transfer arm 46 and by the subsequent rotational movement of transfer arm 46 with wafer 12 thereon relative to vacuum chuck 34 associated with wafer processing module 32.

An indexer module, similar to indexer module 18, and a cassette holder, similar to cassette holder 10, can be placed after the last process module in the wafer processing system. The operation of the foregoing indexer module would be similar to that of indexer module 18 and would be utilized to ensure that the wafers are positioned properly for insertion into another cassette holder after processing has been completed, thus minimizing any damage to the wafers during the insertion process.

From the foregoing, it is apparent that the present invention has numerous advantages over the prior art. For example, since sliding motion is not involved in the centering of the wafer on the alignment chuck or the vacuum chuck, particles which could contaminate the wafer are not produced. In addition, the apparatus of the present invention requires minimal additional mechanisms or components in order to accomplish the transfer of the wafer. Thus, the centering device of the present invention requires considerably less space above the processing plane. Furthermore, the present invention has the ability to both geometrically and/or mass center the wafer on the rotatable vacuum chuck. In contrast, the prior art devices typically have the ability to center the wafer on the chuck either geometrically or by mass centering.

## Claims

1. Apparatus for centering a wafer (12) in a wafer processing system comprising:

    means (40, 42) for transferring the wafer between stations (22, 30, 32) within the wafer processing system, said transferring means being rotatable from a first position to a second position; and

    means for determining the position of the wafer at a station, said determining means producing a signal representative of the position of said wafer with respect to said station, said station and the wafer being rotationally indexable to substantially align the wafer and the center of said station with the arcuate path traversed by the wafer relative to said station when the wafer is transported by said transferring means from said first position to said second position.

2. The apparatus as defined in claim 1 wherein said transferring means is a transfer arm (40) rotatable about a pivot point adjacent one and thereof.

3. The apparatus as defined in claim 1 wherein said determining means is a sensing device (54) located in proximity to the wafer and said station.

4. The apparatus as defined to claim 1 wherein said determining means is a sensing device (54) located within said transferring means.

5. The apparatus as defined in claim 2 wherein said determining means is a sensing device (54) located within said transfer arm and positioned so as to be adjacent the opposite end of said transfer arm.

6. The apparatus as defined in claim 1 wherein said determining means produces said signal in response to the rotation of said wafer.

7. The apparatus as defined in claim 1 further including means (52) for securing the wafer to said transferring means when the wafer is transported by said transferring means from said first position to said second position.

8. The apparatus as defined in claim 7 wherein said securing means comprises vacuum applied to the wafer by said transferring means.

9. The apparatus as defined in claim 8 wherein said vacuum is applied to the wafer through a vacuum port (52) located in said transferring means.

10. The apparatus as defined in claim 1 wherein said station is a wafer processing station in said wafer processing system.

11. The apparatus as defined in claim 1 wherein said station (22) and the wafer are rotationally indexable to substantially align a vector defining the distance and direction between the geometric center of the wafer and the center of rotation of said station with the arcuate path traversed by the wafer relative to said station when the wafer is transported by said transferring means from said first position to said second position.

12. The apparatus as defined in claim 1 wherein said station (22) and the wafer (12) are rotationally indexable to substantially align a vector defining the distance and direction between the center of mass of the wafer and the center of rotation of said station with the arcuate path traversed by the wafer relative to said station when the wafer is transported by said transferring means from said first position to said second position.

13. Apparatus for centering a wafer (12) in a wafer Processing system comprising:
     means for transferring the wafer between stations within the wafer processing system, said transferring means being a transfer arm (44) rotatable from a first position to a second position; and
     means (54) for determining the position of the wafer at a station, said determining means being located within said transfer arm and producing a signal in response to the rotation of said wafer, said signal being representative of the position of said wafer with respect to said station, said station and the wafer being rotationally indexable to substantially align a vector defining the distance and direction between the center of the mass of the wafer and the center of rotation of said station with the arcuate path traversed by the wafer relative to said station when the wafer is transported by said transfer arm from said first position to said second position.

14. Apparatus for centering a wafer (12) in a wafer processing system comprising:
     means for transferring the wafer between stations within the wafer processing system, said transferring means being a transfer arm (44) rotatable from a first position to a second position; and
     means (54) for determining the position of the wafer at a station, said determining means being located within said transfer arm and producing a signal in response to the rotation of said wafer, said signal being representative of the position of said wafer with respect to said station, said station and the wafer being rotationally indexable to substantially align a vector defining the distance and direction between the geometric center of the wafer and the center of rotation of said station with the arcuate path traversed by the wafer relative to said station when the wafer is transported by said transfer arm from said first position to said second position.

15. A method for centering a wafer (12) in a wafer processing system comprising the steps of:
     placing a wafer on a rotatable chuck (22) at a wafer processing station within the wafer processing system;
     rotating the chuck with the wafer thereon;
     producing a signal in response to the rotation of said wafer, said signal being representative of the position of the center of the wafer with respect to the center of rotation of the chuck;
     removing the wafer from the chuck;
     moving the wafer so that its center substantially coincides with the center of rotation of the chuck; and
     replacing the wafer on the chuck so that said center of the wafer substantially coincides with the center of rotation of the chuck.

16. The method as defined in claim 15 wherein said center of the wafer is its geometric center.

17. The method as defined in claim 15 wherein said center of the wafer is its center of mass.

FIG 1

FIG. 2

CENTER OF MASS
OF WAFER

CENTER OF
ROTATION OF
CHUCK

CHUCK

WAFER

ARC OF
TRANSFER
ARM

_Fig. 3_

CENTER OF MASS
OF WAFER

WAFER

CENTER
OF ROTATION
OF CHUCK

CHUCK

ARC OF
TRANSFER
ARM

_Fig. 4_

WAFER

CENTER OF MASS
OF WAFER

CENTER OF ROTATION
OF CHUCK

CHUCK

ARC OF TRANSFER ARM

_Fig. 5_

8